# EUROPÄISCHE PATENTSCHRIFT

(11) **EP 1 624 739 B1**
(45) Veröffentlichungstag und Bekanntmachung des Hinweises auf die Patenterteilung: **15.10.2008**
(21) Anmeldenummer: 04018409.5
(22) Anmeldetag: 03.08.2004
(51) Int. Cl.: H05K 7/20, B60H 1/22

(54) **Elektrische Heizung für Kraftfahrzeuge**
Electric heating for motor vehicles
Chauffage électrique pour véhicules

(43) Veröffentlichungstag der Anmeldung: 08.02.2006
(73) Patentinhaber: Catem GmbH & Co. KG, 76863 Herxheim bei Landau (DE)
(72) Erfinder: Clade, Michael, 67245 Lambsheim (DE); Kachelhoffer, Patrick, 67160 Seebach (DE); Bohlender, Franz, 67870 Kandel (DE)
(74) Vertreter: Grünecker, Kinkeldey, Stockmair & Schwanhäusser Anwaltssozietät

(56) Entgegenhaltungen:
- EP-A- 1 395 098
- DE-A- 2 815 646
- US-B1- 6 304 451

## Beschreibung

Die Erfindung bezieht sich auf eine elektrische Heizvorrichtung zur Lufterwärmung, die sich insbesondere für den Einsatz als elektrische Zusatzheizung in Kraftfahrzeugen eignet.

Für den Einsatz in Kraftfahrzeugen, insbesondere solchen mit verbrauchsoptimierten Motoren, werden elektrische Heizvorrichtungen zur Beheizung des Innenraums und/oder des Motors verwendet. Eine elektrische Zusatzheizung ist insbesondere nach dem Starten des Motors erforderlich, solange der Verbrennungsmotor noch keine ausreichende Wärmeenergie zur Verfügung stellt. Verbrauchsoptimierte Verbrennungsmotoren erfordern sogar grundsätzlich den Einsatz elektrischer Zusatzheizen.

Der Einsatz solcher Heizvorrichtungen ist jedoch nicht auf den Kraftfahrzeugbereich beschränkt, sie sind auch für eine Vielzahl anderer Einsatzzwecke geeignet, beispielsweise im Bereich von Hausinstallationen (Raumklimatisierung), Industrieanlagen und dergleichen.

Aus EP-A1-1 395 098 ist eine elektrische Heizvorrichtung für Kraftfahrzeuge bekannt. Die beschriebene Heizvorrichtung umfasst mehrere zu einem Heizblock zusammengesetzte Heizelemente. Der Heizblock wird zusammen mit einer Steuervorrichtung zur Ansteuerung der Heizelemente in einem gemeinsamen Rahmen gehalten. Die Steuervorrichtung bildet so mit dem in dem Rahmen gehaltenen Heizblock eine bauliche Einheit. Die Steuervorrichtung umfasst eine Leistungselektronik mit elektronischen Schaltern, die jeweils mit einem Kühlkörper versehen sind. Die Steuervorrichtung ist so angeordnet, dass ein Teil des zu erwärmenden Luftstroms die Steuervorrichtung, insbesondere die Kühlelemente, zur Kühlung der elektronischen Schalter anströmt.

Die elektronischen Schalter, insbesondere in Form von Leistungstransistoren, die den Strom steuern, der den Heizelementen zugeführt wird, sind mit einer Seite direkt auf einer Leiterplatte montiert. Zur Abführung der von den Leistungstransistoren erzeugten Verlustwärme ist auf der gegenüberliegenden Seite der Leiterplatte ein Kühlelement oder -blech vorgesehen. Ein solches Kühlelement, das direkt den Leistungstransistor kontaktiert, kann die Verlustwärme des Leistungstransistors auf einfache Weise und in ausreichender Menge abführen.

Als Kühlelement kommt ein U-förmig gestalteter Kühlkörper zum Einsatz mit Kühlrippen bzw. Fingern, die von einer Grundfläche abstehen. An der Unterseite des Kühlkörpers ist ein Zapfen vorgesehen, der in die Leiterplatte zur Kontaktierung des Leistungstransistors einsetzbar ist.

Eine solche herkömmliche Anordnung ist jedoch aufwändig in der Herstellung, da insbesondere der Kühlkörper eine komplizierte Form aufweist. Nachteilig an dieser Heizvorrichtung ist des Weiteren die Klemmbefestigung des Kühlelementes an dem Transistor. Diese Befestigung erfordert im Anschluss an das Einsetzen des Kühlkörpers einen weiteren Arbeitsgang zur Befestigung einer Klammer, die den Kühlkörper hält. Zudem ist die Klemmung nicht in der Lage, Unebenheiten in der Anlagefläche von Transistor und der Oberfläche des durch die Leiterplatte ragenden Zapfenelementes auszugleichen. Dadurch wird der Wärmeübergang unkalkulierbar beeinträchtigt, und die Anlagefläche ist nicht in der Lage, die Verlustwärme vom Leistungstransistor über der gesamten Transistorfläche gleichmäßig abzuleiten.

Alternativ ist vorgesehen, das Kühlelement zweiteilig auszubilden. Dazu wird ein Wärmeleitelement in die Leiterplatte eingesetzt und mit dem der Transistor an der Anlagefläche verlötet. Auf das Wärmeleitelement wird ein Kühlkörper aufgeklebt. Dieser Kühlkörper ist z.B. L-förmig gestaltet mit einer Grundfläche und von dieser Grundfläche abstehenden Kühlrippen. Mit einer solchen Kühlelementanordnung kann die Klemmung entfallen und gleichzeitig kann ein zuverlässig hoher Wärmeübergangswert an der Anlagefläche von Transistor und der Oberfläche des durch die Leiterplatte ragenden Wärmeleitelements sichergestellt werden.

Nachteilig an einer solchen Befestigung ist die aufwändige Herstellung. Insbesondere ist es notwendig, für jedes Kühlelement den Kühlkörper und das Wärmeleitelement separat herzustellen. Zusätzlich fallen bei der Fertigung der Steuerschaltung mehrere Arbeitsgänge an, um das Wärmeleitelement in die Leiterplatte einzusetzen und den Kühlkörper an dem Wärmeleitelement zu befestigen.

Zur Vereinfachung der Befestigung des Kühlkörpers ist außerdem vorgeschlagen, den Kühlkörper mit Hilfe des Wärmeleitelements an der Leiterplatte zu befestigen. Dazu ist das Wärmeleitelement an dem aus der Leiterplatte herausragenden Ende mit einem seitlich vorspringenden Abschnitt versehen. In der Grundfläche des Kühlkörpers ist eine entsprechende Öffnung vorgesehen, durch die das Wärmeleitelement durch die Leiterplatte ragt. Der seitliche Vorsprung des Wärmeleitelements fixiert den Kühlkörper an der Leiterplatte.

Diese Bauform eines Kühlelementes erfordert jedoch immer noch die Bereitstellung von mehreren Bauteilen für ein Kühlelement. Des Weiteren ist es nötig, den Kühlkörper zunächst auf die Leiterplatte aufzusetzen und vorläufig zu fixieren, bis das Wärmeleitelement eingesetzt und befestigt ist. Dadurch bleibt die Herstellung der elektrischen Heizvorrichtung zeitaufwändig und kompliziert.

Aus der Druckschrift DE-A-28 15 646 ist ein SMD-Baugruppenträger bekannt, auf dem zur Kühlung der SMD-Bauelemente auf ihrer Unterseite wärmeleitende Bolzen angebracht sind, die durch den Baugruppenträger hindurch ragen. Die Bolzen sind wärmeleitend mit dem Bauelement verklebt und könne so die überschüssige Wärme an die Luft abgeben.

Problematisch an dieser Anordnung ist jedoch die mechanischen Stabilität, insbesondere der Verbindung zwischen Bauelement und Kühlkörper, um einen guten Wärmeübergang sicherzustellen. Dieses Problem besteht vor allem bei großen Kühlkörpern, wie sie zur Abführung hoher Verlustleistungen erforderlich sind.

Aufgabe der Erfindung ist es daher, eine einfache herzustellende Heizvorrichtung mit ausreichender Abfuhr der Verlustwärme anzugeben.

Diese Aufgabe wird mit den Merkmalen des Patentanspruchs 1 gelöst.

Erfindungsgemäß ist das Kühlelement als stiftförmiger Vollkörper ausgebildet, der zur Anbindung an den Leistungstransistor in eine Öffnung in der Leiterplatte eingesetzt ist. Die Abgabe der an die Kühlelemente übertragenen Wärme erfolgt auf besonders effiziente Weise dadurch, dass das Kühlelement über in einem Gehäuse der Heizvorrichtung vorgesehene Fensteröffnungen von der zu erwärmenden Luft umströmbar ist. Dazu ragt das Kühlelement entsprechend weit aus der Leiterplatte heraus. Durch das Vorsehen von Fensteröffnungen kann der zur Kühlung der Leistungselektronik verwendete Luftdurchsatz gesteuert werden. Vorzugsweise sind die Fensteröffnungen so angeordnet, dass allein die Kühlelemente von Außenluft umströmbar sind. Auf diese Weise ist die zur Kühlung der Leistungselektronik verwendete Luftmenge so einstellbar, dass keine Zonen unterschiedlicher Temperatur im erwärmten Luftstrom auftreten, so dass insbesondere der Kühlluftstrom und der von den Radiatorelementen aufgeheizte Luftstrom in etwa dieselbe Ausgangstemperatur aufweisen. Auf diese Weise wird die Effektivität der gesamten Heizvorrichtung

nicht durch den zur Kühlung der Steuerelektronik abgezweigten Luftstrom vermindert.

Erfindungsgemäß ist in dem Gehäuse eine Halterung zur Fixierung des aus der Leiterplatte herausragenden Abschnitt des Kühlelementes vorgesehen. Durch eine solche Halterung ist ein Schutz der Kühlelemente gegen mechanische Belastungen gewährleistet. So kann sichergestellt werden, dass auch nach langer Betriebsdauer die feste Verbindung zwischen der Leiterplatte und den Kühlelementen gewährleistet ist. Des Weiteren wird es möglich, größere und damit schwerere Kühlelemente einzusetzen, um somit eine höhere Kühlwirkung zu erzielen.

In bevorzugter Weise wird die Halterung durch eine Querstrebe des Gehäuses gebildet ist, die eine Öffnung oder Vertiefung aufweist, in die das Kühlelement hineinragt. In diese Öffnung oder Vertiefung lassen sich die schon an der Leiterplatte befestigten Kühlelemente einfach einsetzten. Damit vereinfacht sich der Einbau der Steuerschaltung in die Heizvorrichtung.

Vorzugsweise ist die Halterung als eine zwischen sich gegenüberliegenden Fensteröffnungen angeordnete Querrippe ausgebildet. Dieser Aufbau ermöglicht eine mechanische Fixierung des Kühlelementes innerhalb der Fensteröffnungen, wobei der durch die Fensteröffnungen strömende Luftstrom nur minimal beeinträchtigt wird. Dementsprechend kann die Länge des Kühlelements so gewählt werden, dass das Kühlelement an einem möglichst hohen Flächenanteil von Luft umströmt wird. Insbesondere ist es nicht nötig einen zusätzlichen Befestigungsabschnitt am Kühlelement vorzusehen. Zudem bewirkt die Querrippe gleichzeitig eine Versteifung des Gehäuses im Bereich der Fensteröffnungen.

Durch die besondere Form lässt sich ein solches Kühlelement zum Einen auf einfache Weise herstellen. Deshalb sind die Herstellungskosten für das Kühlelement niedrig. Außerdem können die Kühlelemente in einem einzigen Arbeitsgang an der Leiterplatte montiert werden, so dass sich die Fertigung der Heizvorrichtung vereinfacht,

insbesondere kann die Steuerschaltung in kürzerer Zeit bestückt werden. Zum Anderen ist die Kühlwirkung eines solchen Kühlelementes bei entsprechender Dimensionierung ausreichend gewährleistet.

Gemäß einer vorteilhaften Ausgestaltung der Erfindung weist das Kühlelement eine im Wesentlichen zylindrische Form auf. Eine solche Formgebung ermöglicht die weitere Senkung der Herstellungskosten.

Vorzugsweise ist der aus der Leiterplatte herausragende Abschnitt des Kühlelements mit radialen Vorsprüngen oder Einkerbungen versehen. Diese Vorsprünge bzw. Einkerbungen bewirken eine Verwirbelung der am Kühlelement vorbeigeführten Luft, so dass eine effizientere Wärmeabfuhr erzielt wird.

Das Kühlelement ist vorzugsweise mit seinem leiterplattenseitigen Abschnitt in die Öffnung eingepresst. Durch diese Befestigungsart verringert sich die für die Herstellung der Heizvorrichtung erforderlichen Arbeitsschritte. Insbesondere wird gleichzeitig mit dem Einsetzen des Kühlelements in die Leiterplatte eine belastbare Befestigung des Kühlelements an der Leiterplatte in einem einzigen Arbeitsgang hergestellt.

Gemäß einer vorteilhaften Ausgestaltung der Erfindung ist der leiterplattenseitigen Abschnitt des Kühlelements mit einer Rändelung versehen, die sich beim Einpressen mit der Leiterplatte verzahnt. Eine solche Ausgestaltung ermöglicht ein leichtes Einsetzen und gleichzeitig eine mechanische Fixierung. Auf diese Weise ist das Kühlelements nach dem Einsetzen sofort in der Leiterplatte mechanisch fixiert.

Vorzugsweise hat der leiterplattenseitige Abschnitt des Kühlelements einen größeren Umfang als der aus der Leiterplatte herausragende Abschnitt des Kühlelements. Durch diese Formgebung ist das Kühlelement von der gleichen Seite in die Leiterplatte einsetzbar von der aus auch die Bestückung der Leiterplatte mit elektronischen Komponenten wie beispielsweise den Leistungstransistoren, erfolgt. Somit vereinfacht sich die Herstellung der Steuerschaltung.

Wenn zusätzlich der leiterplattenseitige Abschnitt eine konische Form aufweist, die sich in Richtung des aus der Leiterplatte herausragenden Abschnitts verjüngt, ist das Kühlelement durch den auf diesem befestigten Leistungstransistor gegen ein Herausfallen gesichert.

Gemäß einer bevorzugten Ausgestaltung der Erfindung ist das Kühlelement aus Kupfer oder Aluminium gefertigt. Ein aus Kupfer bestehendes Kühlelement zeichnet sich durch eine hohe Wärmeleitfähigkeit aus. Dadurch tritt ein nur sehr geringer Temperaturgradient zwischen dem Leistungstransistor und der Oberfläche des Kühlelements auf, so dass die im Leistungstransistor erzeugte Wärme besonders effizient an die umgebende Luft abgegeben wird. Ein aus Aluminium gefertigtes Kühlelement hat eine gute Wärmeleitfähigkeit und zeichnet sich durch günstigere Materialkosten sowie eine geringere Masse aus.

Die Leiterplatte ist vorzugsweise in einem Bereich um den Rand der Öffnung mit Kupfer beschichtet. Dadurch wird eine besonders belastbare Befestigung des Kühlelements an der Leiterplatte erzielt.

Gemäß einer vorteilhaften Ausgestaltung weist das Kühlelement einen kreisförmigen Querschnitt mit einem Durchmesser zwischen 4 und 11 mm auf. Vorzugsweise beträgt der Durchmesser zwischen 6 und 9 mm. Die Länge des Kühlelements beträgt vorzugsweise zwischen 15 und 40 mm. Besonders bevorzugt wird eine Länge zwischen 20 und 30 mm. Derart dimensionierte Kühlelemente führen die in den Leistungstransistoren erzeugte Wärme in ausreichender Weise ab. Zudem ist das Gewicht der Kühlelemente niedrig, so dass die Leiterplatte und die Verbindung zwischen Kühlelement und Leiterplatte nicht unnötig belastet wird.

Gemäß einer vorteilhaften Ausgestaltung der Erfindung ist ein Kühlblech an dem Kühlelement befestigt. Durch ein solches Kühlblech kann die Kühlwirkung weiter erhöht werden. Vorzugsweise ist das Kühlblech an die thermischen und mechanischen Bedingungen, die die jeweilige Heizung kennzeichnen, durch geeignete Auswahl des Materials, der Oberfläche und der Form angepasst. Somit erhält man auf einfache Weise ein optimal angepasstes Kühlelement ohne das Grundelement, den stiftförmigen Körper, anzupassen.

Vorzugsweise ist das Kühlblech zur Befestigung an dem Kühlelement auf das Kühlelement aufgeklemmt. Auf diese Weise wird ein zweiteiliges Kühlelement realisiert, bei dem das Kühlblech sicher an dem stiftförmigen Kühlkörper befestigt ist. Das Aufklemmen erfolgt in einem einfachen effizienten Arbeitsschritt, der keine Wartezeit, wie sie z.B. für das Aushärten eines Klebers erforderlich wäre, bedingt.

Das Kühlblech ist vorzugsweise aus Aluminium oder Kupfer gefertigt. Beides sind Materialien mit hoher Wärmeleitfähigkeit, die sich zudem gut verarbeiten lassen.

Zur besseren mechanischen Fixierung des Kühlelements ist das Kühlblech vorzugsweise an einem Gehäuse der Heizvorrichtung befestigt. In einer solchen Anordnung dient das Kühlblech neben der Erhöhung der Kühlwirkung zugleich dem Zweck der zusätzlichen mechanischen Befestigung des Kühlelementes. Dadurch kann auf effiziente Weise ein sicherer Betrieb der Heizung über eine lange Zeitdauer gewährleistet werden.

Um einen guten Wärmeübergangswert zwischen dem Leistungstransistor und dem Kühlkörper zu erzielen, ist der Leistungstransistor vorzugsweise mit dem jeweiligen in die Öffnungen der Leiterplatte eingesetzten Kühlelement verlötet.

Gemäß einer weiteren bevorzugten Ausgestaltung der Erfindung ist der Leistungstransistor mit dem jeweiligen in die Öffnungen der Leiterplatte eingesetzten Kühlelement verklebt. Dadurch wird die thermische Belastung, die der Leistungstransistor während eines Verlötens mit dem Kühlelement ausgesetzt wäre, vermieden. Vorzugsweise wird die Unterseite des Leistungstransistor erst nach der Durchführung eines Lötprozesses auf die Öffnung aufgebracht und mit dem Kühlelement verklebt.

Bei einer Verklebung können verschiedene Kleber vorteilhaft verwendet werden. Ein Epoxidharzkleber ermöglicht eine besonders feste Verbindung beider Komponenten, insbesondere auch dann, wenn das Kühlelement zusätzlich mit der Leiterplatte verklebt wird. Ein Silikonkleber kann unterschiedliche Ausdehnungskoeffizienten der verklebten Materialien ausgleichen. Ein weiterer vorteilhaft einsetzbarer Kleber ist ein Acrylkleber. Der Vorteil dieser Kleber liegt insbesondere darin, dass keine planparallelen Flächen der Einzelteile, des Kühlelementes und des Leistungstransistors, erforderlich sind, da Unebenheiten durch die Kleber ausgeglichen werden.

Um die Gefahr, die von einem auf elektrischen Potential liegenden Kühlelement mit seinen von außen zugänglichen Oberflächen ausgeht, zu beseitigen, ist die Oberfläche des Kühlelementes auf der Außenseite mit einer elektrisch isolierenden Beschichtung versehen. Mit einer solchen Maßnahme kann auf einfache Weise ein elektrischer Kurzschluss, beispielsweise durch in den zu erwärmenden/erwärmten Luftstrom fallende Metallteile, verhindert werden.

Vorzugsweise ist das Kühlelement nur in den Bereichen mit einer elektrisch isolierenden Schicht versehen, die von außen zugänglich sind, insbesondere also auf dem zwischen die Fensteröffnungen ragenden Abschnitt.

Weitere vorteilhafte Ausgestaltungen der Erfindung sind in den Unteransprüchen angegeben.

Im folgenden wird die Erfindung anhand der beiliegenden Zeichnungen beschrieben, in denen:
- Fig. 1 a und 1 b: eine Aufsicht bzw. Seitenansicht einer erfindungsgemäßen elektrischen Heizvorrichtung zeigen,
- Fig. 2: eine Detailansicht der mit Bauelementen und Kühlelementen bestückten Leiterplatte der Steuervorrichtung der erfindungsgemäßen Heizvorrichtung zeigt,
- Fig. 3a und 3b: eine Aufsicht bzw. Seitenansicht einer erfindungsgemäßen Ausführungsform eines Kühlelements zeigen,
- Fig. 4a: eine Seitenansicht einer weiteren Ausführungsform einer erfindungsgemäßen elektrischen Heizvorrichtung zeigt, bei der innerhalb von Fensteröffnungen Querrippen zur Befestigung der Kühlelemente vorgesehen sind,
- Fig. 4b: eine Detailansicht im Bereich einer Fensteröffnung dieser Heizvorrichtung zeigt,
- Fig. 4c: einen Schnitt entlang der Linie A-A innerhalb dieser Detailansicht zeigt,
- Fig. 5a: eine Seitenansicht einer weiterer Ausführungsform einer erfindungsgemäßen elektrischen Heizvorrichtung zeigt, bei der zusätzliche Kühlbleche auf den Kühlelementen montiert sind,
- Fig. 5b: eine Detailansicht im Bereich einer Fensteröffnung dieser Heizvorrichtung zeigt und
- Fig. 5c: einen Schnitt entlang der Linie A-A innerhalb dieser Detailansicht zeigt.

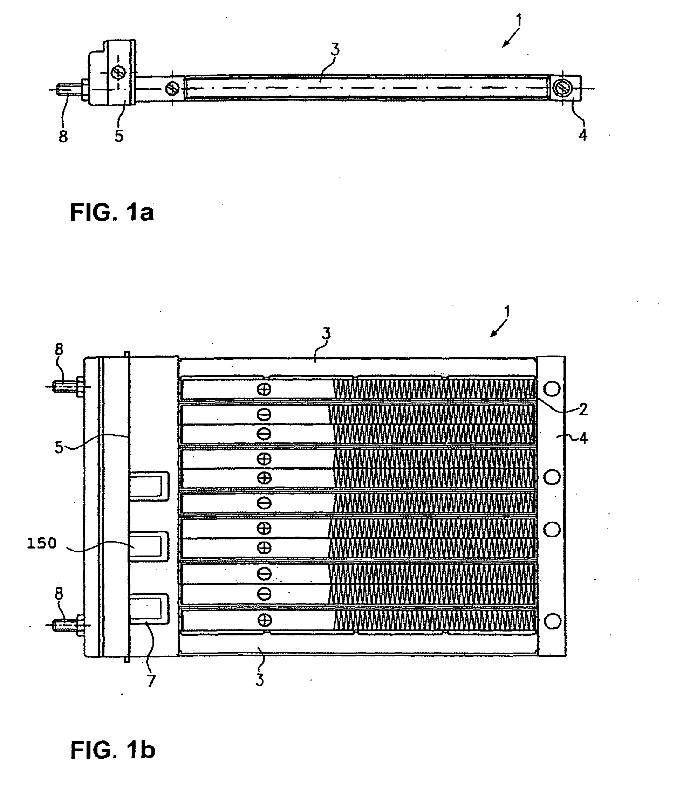

In Fig. 1 a ist eine Seitenansicht der erfindungsgemäßen elektrischen Heizvorrichtung 1 gezeigt. Fig. 1b zeigt eine Aufsicht auf die elektrische Heizvorrichtung 1. Die elektrische Heizvorrichtung 1 enthält einen Heizblock, der aus einer Mehrzahl geschichteter oder gestapelter Heizelemente 2 besteht. Jedes Heizelement 2 besteht aus einem Widerstandsheizelement und benachbart dazu angeordneten Radiatoren oder Wärmeleitblechen. Als Widerstandsheizelemente werden vorzugsweise PTC-Elemente verwendet. Der Heizblock aus den Heizelementen 2 wird in einem Rahmen gehalten. Dieser Rahmen besteht aus gegenüberliegenden Längsholmen 3 und senkrecht dazu angeordneten Seitenholmen 4 und 5. Die Holmen des Rahmen sind entweder Metall oder aus Kunststoff gefertigt.

Während die Längsholme 3 im wesentlichen symmetrisch aufgebaut sind, unterscheiden sich die beiden Seitenholme 4 und 5 in der in Fig. 1 dargestellten Ausführungsform. Im Gegensatz zum Seitenholm 4 ist der Seitenholm 5 als einseitig offener Kasten ausgebildet. Die Öffnung dieses kastenförmigen Seitenholms 5 liegt auf der den Heizelementen 2 gegenüberliegenden Seite des Seitenholms 5. In diesen Kasten ist eine Steuervorrichtung einsetzbar, die die Wärmeabgabe der einzelnen Heizelemente 2 durch Steuerung des den Heizelementen 2 zugeführten Stromes steuert. Die offene Seite des als Kasten ausgebildeten Seitenholms 5 wird nach dem Einsetzen der Steuerschaltung mit einem aufsteckbaren oder aufklipsbaren Deckel verschlossen.

Die Leiterplatte der Steuervorrichtung ist nach dem Einsetzen vorzugsweise senkrecht zur Rahmenebene angeordnet, es ist jedoch auch eine parallele Anordnung möglich (nicht dargestellt).

Die Heizvorrichtung 1 wird über zwei Anschlussbolzen 8 mit Strom versorgt. Sie sind so ausgebildet, dass sie problemlos die geforderten Heizströme leiten können. Die Anschlussbolzen 8 ragen in der in Fig. 1 dargestellten Ausführungsform auf der Seite heraus, auf der der kastenförmige Seitenholm 5 offen ist.

Auf derselben Seite ist ein weiterer Steckersockel zur Ansteuerung der Steuervorrichtung vorgesehen, der in Fig. 1 nicht dargestellt ist.

Der Seitenholm 5 weist auf den Seiten, die in der Flächenebene des Rahmens liegen, Fensteröffnungen 7 auf. Diese Fensteröffnungen 7 sind so angeordnet, dass sie ebenfalls in dem zu erwärmenden Luftstrom liegen. Zwischen den sich gegenüberliegenden Fensteröffnungen 7 sind Kühlelemente 150 angeordnet, die den Leistungselektronikbauelementen der Steuerschaltung zugeordnet sind. Beim Betrieb wird nicht nur der Heizblock aus den Heizelementen 2, sondern ebenfalls die Fensteröffnungen von zu erwärmender Luft durchströmt.

Die Wahl der Größe der Fensteröffnungen 7 erlaubt, den Anteil der Luftmenge zu bestimmen, die an den Kühlelementen 150 vorbeiströmt. Erfindungsgemäß wird der Luftdurchsatz so eingestellt, dass die durch den Heizblock geströmte Luft und die an den Kühlelementen 150 vorbeigeströmte Luft möglichst geringe Temperaturunterschiede aufweisen. Nur wenn die durch die Fensteröffnungen 7 geströmte Luft in ihrer Temperatur der durch den Heizblock geströmten Luft möglichst nahe kommt, wird eine möglichst hohe Effizienz beim Betrieb der Heizvorrichtung erreicht.

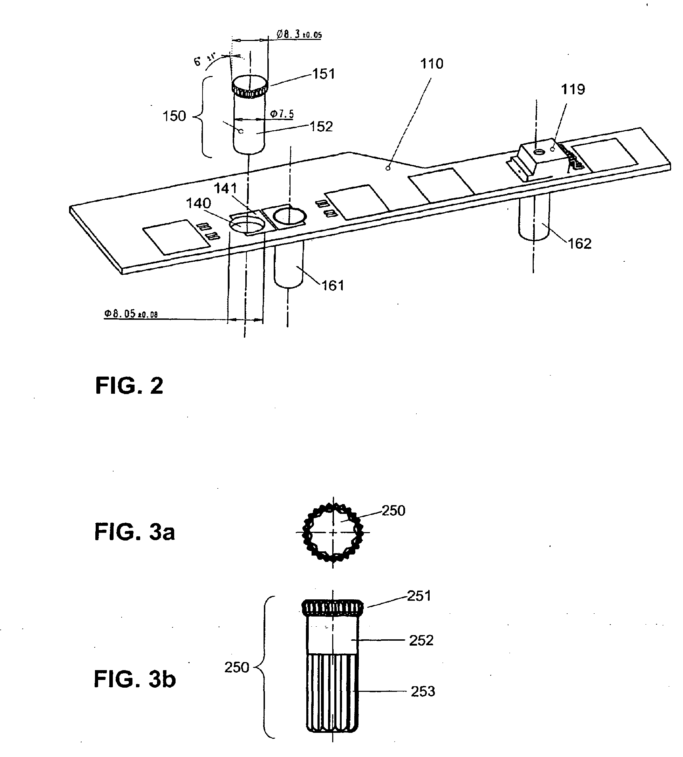

Figur 2 zeigt eine Detailansicht der innerhalb des kastenförmig ausgebildeten Seitenholms angeordneten Steuervorrichtung. Auf einer Leiterplatte 110 ist neben Leistungselektronikbauelementen eine Steuerelektronik (nicht dargestellt) vorgesehen. Die Steuerelektronik bestimmt die von den Leistungselektronikbauelementen, insbesondere den Leistungstransistoren 119, an das diesen jeweils zugeordnete Heizelement 2 abzugebende Strommenge.

Die Leiterplatte ist nur einseitig mit Bauelementen bestückt. Entsprechend der Anzahl von Heizstufen weist die Leiterplatte waagerecht auf dieser befestigte Leistungstransistoren 119 auf. Im gezeigten Ausführungsbeispiel sind drei Heizstufen und dementsprechend drei Leistungstransistoren vorgesehen. Jeder Leistungstransistor 119 ist an seinem Ausgangsanschluss fest mit der Leiterplatte 110 verlötet.

Jeder der Leistungstransistoren 119 ist zur Abführung der Verlustwärme mit einem Kühlelement 150 verbunden. Zur Abführung der Wärme vom Transistor zum Kühlelement kontaktiert das Kühlelement den Transistor direkt. Eine solche Kontaktierung erfolgt erfindungsgemäß über eine unter dem Transistor angeordnete Öffnung 140.

Das Kühlelement 150 ist als stiftförmiger Körper ausgebildet. Um die Herstellung zu vereinfachen ist die Form des Kühlelementes im Wesentlichen zylindrisch. Insbesondere ist ein leiterplattenseitiger Abschnitt 151 vorgesehen, der in die Leiterplatte eingesetzt wird und ein Abschnitt 152, der aus der Leiterplatte 110 an der unteren Seite senkrecht herausragt.

Der leiterplattenseitige Abschnitt 151 ist mit einer Rändelung versehen, die es ermöglicht, das Kühlelement mit der Leiterplatte mechanisch zu verbinden. Erfindungsgemäß erfolgt die Befestigung des Kühlelements dadurch, dass das Kühlelement in die Leiterplatte eingepresst wird, so dass der Abschnitt 151 eine feste Verbindung mit dem Rand der Öffnung 140 eingeht. Die Rändelung sorgt für eine Verzahnung des Abschnitts 151 mit dem Rand der Öffnung 140, so dass sofort nach dem Einpressen eine belastbare Verbindung erreicht wird. In der gezeigten Ausführungsform weist der leiterplattenseitige Abschnitt 151 eine leicht konische Form auf. Durch diese Formgebung wird das Einsetzen des Kühlelements in die Leiterplatte vereinfacht.

Der aus der Leiterplatte herausragende Abschnitt 152 des Kühlelements hat einen geringfügig geringeren Durchmesser als der Abschnitt 151, der in die Leiterplatte eingepresst wird. Dadurch ist es möglich, das Kühlelement von der gleichen Seite, von der aus die Bestückung der Platine mit elektrischen Bauelementen erfolgt, in die Leiterplatte einzusetzen.

In Fig. 2 ist außerdem ein in die Leiterplatte eingesetztes Kühlelement 161 sowie ein Kühlelement 162 gezeigt, auf dem ein Leistungstransistor 119 befestigt ist. Die Kühlelemente werden in die Leiterplatte so eingesetzt, dass die Stirnseite ihres leiterplattenseitigen Abschnitts 151 mit der Oberfläche der Leiterplatte 110 bündig abschließt. Im weiteren Produktionsverlauf wird an der vorgesehenen Stelle ein Leistungstransistor über dem Kühlelement befestigt. Dies geschieht beispielsweise dadurch, dass der Leistungstransistor an der Transistorunterseite und gegebenenfalls an seinen seitlich herausgeführten Anschlüssen mit der Leiterplatte verlötet wird. Dafür kann um den Rand der Bohrung eine metallisierte Fläche 141 vorgesehen sein, so dass der Leistungstransistor mit dem Kühlelement sowie mit der Leiterplatte verlötet ist.

Eine direkte Kontaktierung der Leistungstransistoren 119 über eine Bohrung in der Leiterplatte 110 ist insbesondere für Leistungstransistoren in SMD-Ausführung vorteilhaft. Solche Transistoren weisen bauartbedingt keine Kühlfahnen auf, an denen Kühlelemente befestigbar sind.

Um die Festigkeit der Verbindung zwischen dem Kühlelement und der Öffnung 140 in der Leiterplatte zu erhöhen, kann zusätzlich der Rand der Öffnung 140 metallisiert werden. Vorzugsweise wird die Öffnung in einem galvanischen Verfahren in einer Schichtstärke von ca. 50 µm mit Kupfer beschichtet. In die beschichtete Öffnung wird das Kühlelement mit einer Einpresskraft von etwa 800 Newton eingesetzt. Dadurch entsteht eine mechanische Verbindung zwischen dem Kühlelement und der Leiterplatte, die starken Belastungen standhält. Insbesondere hält diese Verbindung den in einem Kraftfahrzeug üblicherweise auftretenden Belastungen über eine lange Betriebsdauer stand.

In der gezeigten Ausführungsform hat die Öffnung 140 einen Durchmesser von 8,05 mm. Das Kühlelement hat an seinem oberen leiterplattenseitigen Abschnitt einen Durchmesser von 8,3 mm. Zudem weist dieser Abschnitt eine konische Form auf, derzufolge die Umfangsfläche mit einem Winkel von 6° gegen die Längsachse des Kühlelements geneigt ist. Der Abschnitt 152, der nach dem Einsetzen aus der Leiterplatte herausragt, hat in dieser Ausführungsform einen Durchmesser von 7,5 mm.

Erfindungsgemäß können die Durchmesser der Öffnung und des Kühlelements in einem weiten Bereich variiert werden. Sinnvolle Durchmesser für das Kühlelement liegen zwischen 4 und 11 mm. Vorzugsweise werden Durchmesser zwischen 6 und 9 mm verwendet. Die Länge des Kühlelements kann zwischen 15 und 40 mm betragen. Vorzugsweise wird eine Länge von 20 und 30 mm gewählt. Insbesondere ist die Länge so gewählt, dass der aus der Leiterplatte vorstehende Abschnitt 152 in einen Luftstrom, der sich zwischen gegenüberliegenden Fensteröffnungen 7 ausbildet, hineinragt. Dadurch erfolgt ein effizienter Transport, der an das Kühlelement übertragenen Wärme.

Die Form des Kühlelements ist besonders im Hinblick auf die einfache und effiziente Herstellbarkeit hin optimiert. Durch eine entsprechende Dimensionierung des Durchmessers sowie der Länge des Kühlelements wird jedoch ein ausreichender Abtransport der durch die Leistungstransistoren erzeugten Wärme erreicht.

Um eine möglichst gute Kühlwirkung zu erzielen, ist das Kühlelement entweder aus Kupfer oder Aluminium gefertigt. Kupfer ist ein hervorragender Wärmeleiter. Ein daraus gefertigtes Kühlelement weist einen geringen Temperaturgradienten zwischen der Stirnseite, an der die Wärme vom Leistungstransistor übertragen wird, und dem Abschnitt 152, der die Wärme an den vorbeiströmenden Luftstrom abgibt, auf. Dadurch wird die vom Leistungstransistor erzeugte Wärme sehr effizient abgeführt. Durch die gute Wärmeleitfähigkeit ist es möglich, die Länge und den Durchmesser des Kühlelements gering zu halten.

Ein Kühlelement aus Aluminium weist eine gute Wärmeleitfähigkeit auf. Ein daraus gefertigtes Kühlelement benötigt im Vergleich zu einem Kupferkühlelement eine größere Fläche, um die Wärme an die durchströmende Luft abzugeben. Da Aluminium jedoch eine wesentlich geringere Dichte als Kupfer hat, ist das aus Aluminium gefertigte Kühlelement leichter als ein Kupferkühlelement, so dass die mechanische Belastung der Verbindung zwischen dem Kühlelement und der Leiterplatte geringer ist. Des Weiteren sind die Materialkosten für Aluminium deutlich niedriger als für Kupfer.

Die mit dem Kühlelement verbundene Unterseite des Leistungstransistors liegt üblicherweise auf Pluspotenzial. Um die Betriebssicherheit der elektrischen Heizvorrichtung zu erhöhen, ist es jedoch wünschenswert, alle nach außen zugänglichen Oberflächen der Heizvorrichtung potenzialfrei zu halten. Durch eine elektrisch isolierende (jedoch gut wärmeleitende) Beschichtung wird eine elektrische Isolierung der Kühlelemente 150 erreicht. Vorzugsweise ist diese Beschichtung nur an den Stellen der Oberfläche vorgesehen, die von außen zugänglich sind, die beispielsweise in den Fensteröffnungen 7 liegen.

Eine Befestigung des Leistungstransistors 119 auf dem Kühlelement 150 kann, wie oben beschrieben, durch Verlöten erfolgen. Beim Verlöten des Leistungstransistors mit dem Kühlelement tritt jedoch bedingt durch die hohe Masse des Kühlelements eine hohe thermische Belastung des Leistungstransistors auf. Als Alternative zur Verlötung des Leistungstransistors mit dem Kühlelement ist es ebenfalls möglich, den Transistor mittels eines gut leitenden Klebers an seiner Unterseite mit der Leiterplatte 110 und dem darin eingesetzten Kühlelement 150 zu verkleben. Dadurch wird die thermische Belastung, die der Leistungstransistor während eines Verlötens mit dem Kühlelement ausgesetzt wäre, vermieden. Somit ist die zur Verfügung stehende Auswahl an Transistoren nicht durch die Anforderungen einer hohe Hitzebeständigkeit eingeschränkt.

Das Verkleben kann beispielsweise im Anschluss an einen Lötprozess, in dem die Elektronikbauelemente und die Anschlussdrähte des Leistungstransistors mit der Leiterplatte verbunden werden, durchgeführt werden. Außerdem tritt durch die Verklebung eine elektrische Isolierung zwischen dem Leistungstransistor und dem Kühlelement auf, so dass die Oberfläche des Kühlelements potenzialfrei bleibt.

Für die Verklebung können verschiedene Kleber verwendet werden. Ein Epoxidharzkleber ermöglicht eine besonders feste Verbindung beider Komponenten. Mit einem Silikonkleber können unterschiedliche Ausdehnungskoeffizienten der verklebten Materialien ausgeglichen werden. Des Weiteren kann ein Acrylkleber eingesetzt werden. Bei all diesen Klebern sind keine planparallele Flächen des Kühlelements und der Unterseite des Leistungstransistors erforderlich, da Unebenheiten durch die Kleber ausgeglichen werden. Dadurch vereinfacht sich die Herstellung des Kühlelements. Außerdem sind die Präzisionsanforderungen für das Einsetzen des Kühlelements in die Leiterplatte geringer.

Gemäß der beschriebenen Ausgestaltung einer elektrischen Heizvorrichtung mit den stiftförmigen Kühlelementen vereinfacht sich die Herstellung der elektrischen Heizvorrichtung. Die beschriebenen Kühlelemente können in einem einzigen Arbeitsgang an der Leiterplatte angebracht werden. Dadurch kann die Steuerschaltung in kurzer Zeit bestückt werden und eine einfache Fertigung der Heizvorrichtung wird erzielt. Die Herstellungskosten für die Heizvorrichtung fallen außerdem geringer aus, da die Herstellungskosten für das Kühlelement niedrig sind. Bei einer entsprechenden Dimensionierung der Kühlelemente ist eine ausreichende Kühlwirkung der Leistungstransistoren, die die elektrischen Heizelemente steuern, gewährleistet, wobei jedoch im Vergleich zu herkömmlichen Heizvorrichtungen der Herstellungsaufwand für die erfindungsgemäße Heizvorrichtung geringer ist.

Fig. 3a zeigt eine Aufsicht auf ein Kühlelement 250 zum Einsatz in der erfindungsgemäßen elektrischen Heizvorrichtung, das gegenüber dem bisher beschriebenen Kühlelement 150 hinsichtlich der Wärmeabgabe optimiert wurde. Fig. 3b zeigt eine Seitenansicht dieses Kühlelements.

Das abgebildete Kühlelement 250 weist einen leiterplattenseitigen Abschnitt 251 auf, der zur Befestigung in die Leiterplatte eingesetzt wird. Dieser Abschnitt ist in gleicher Weise gestaltet wie der entsprechende Abschnitt 151 des Kühlelements 150. Des Weiteren weist das Kühlelement 250 die Abschnitte 252 und 253 auf, die im eingesetzten Zustand aus der Leiterplatte herausragen. Insbesondere der Abschnitt 253 ist an seiner Oberfläche mit radialen Vorsprüngen oder Einkerbungen versehen. Diese Vorsprünge oder Einkerbungen bewirken jeweils eine Verwirbelung der Luft, die an dem Kühlelement vorbeiströmt. Dadurch wird eine bessere Abgabe der Wärme an die vorbeiströmende Luft erzielt. Bevorzugterweise sind diese Einkerbungen oder Vorsprünge nur in einem Bereich vorgesehen, der sich zwischen den Fensteröffnungen 7 befindet. Durch eine solche Formgebung wird eine bessere Kühlwirkung erzielt, ohne dass sich die Herstellung des Kühlelements unnötig kompliziert gestaltet.

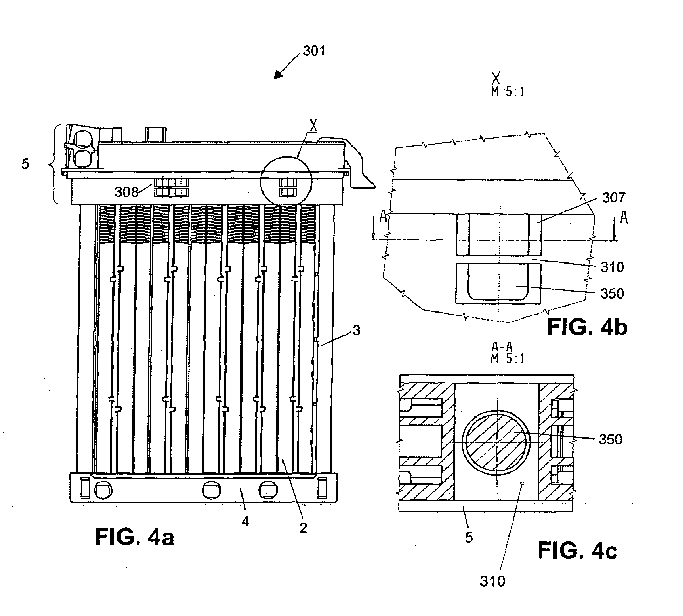

In den Figuren Fig. 4a, Fig. 4b und Fig. 4c ist eine weitere Ausgestaltung der bisher beschriebenen erfindungsgemäßen elektrischen Heizvorrichtung abgebildet. Diese Ausgestaltung betrifft insbesondere das Gehäuse der elektrischen Heizvorrichtung, in das die Steuervorrichtung eingesetzt ist. Fig. 4a zeigt eine Seitenansicht einer solchen elektrischen Heizvorrichtung. In Fig. 4b ist ein Detailausschnitt aus der Fig. 4a vergrößert dargestellt. Fig. 4c stellt einen Schnitt entlang der Linie A-A in Aufsicht dar.

In der dargestellten elektrischen Heizvorrichtung ist eine Steuerschaltung, die im Wesentlichen der in Fig. 2 dargestellten Steuerschaltung entspricht, eingesetzt. Die stiftförmigen Kühlelemente 350 entsprechen den in Fig. 2 oder den in Fig. 3a, 3b gezeigten Kühlelementen. In einem Teil des Gehäuses 5, der die Steuerschaltung beherbergt, sind gemäß dieser erfindungsgemäßen Ausgestaltung Halterungen 310 vorgesehen, die Kühlelemente 350 fixieren. Insbesondere bei längeren Kühlelementen bewirkt eine solche Halterung einen Schutz gegen mechanische Belastungen, denen die Heizvorrichtung im Betrieb eines Kraftfahrzeugs ausgesetzt sind.

Die Halterungen 310, die die Kühlelemente an dem Abschnitt, der von der Leiterplatte herausragt, halten, bewirken, dass sich die Belastung der Verbindung zwischen dem in die Leiterplatte eingesetzten Abschnitt 151 des Kühlelements und der Öffnung 140 in der Leiterplatte verringert. Infolgedessen ist die Haltbarkeit dieser Verbindung deutlich gesteigert. Somit ist für die erfindungsgemäße Heizvorrichtung ein sichererer Betrieb auch über eine lange Betriebsdauer gewährleistet.

Vorzugsweise ist die Halterung durch eine Querstrebe des Gehäuses gebildet, die eine Öffnung oder Vertiefung aufweist, in die der aus der Leiterplatte vorstehende Abschnitt des Kühlelements einsetzbar ist. Durch eine solche Anordnung kann die fertig montierte Steuerschaltung auf einfache Weise in ein Gehäuse eingesetzt werden. Gleichzeitig wird eine gute mechanische Fixierung der Kühlelemente erreicht.

In der in Fig. 4a gezeigten Ausführungsform ist das Gehäuse durch Längsholmen 3 und senkrecht dazu angeordneten Seitenholmen 4 und 5 gebildet. Der Seitenholm 5 ist kastenförmig ausgebildet, um die Steuervorrichtung aufzunehmen. Daher sind die Halterungen in dem kastenförmigen Seitenholm 5 angeordnet. Die vorliegende Erfindung umfasst allerdings auch Ausführungsformen, bei denen die Heizvorrichtung zusammen mit der Steuervorrichtung in einem gemeinsamen Kunststoffgehäuse angeordnet sind. Dementsprechend sind in einem solchen Gehäuse in dem Gehäuseabschnitt, der die Steuervorrichtung aufnimmt, entsprechende Halterungen 310, z.B. durch Querstreben gebildet, vorgesehen, um die Kühlelemente zu fixieren.

Wie in den Figuren Fig. 4a bis Fig. 4c gezeigt, ist die Halterung vorzugsweise als Querrippe ausgebildet, die in den Fensteröffnungen 307 bzw. 308 vorgesehen ist. Ein solcher Aufbau des Gehäuses beeinträchtigt den durch die Fensteröffnungen strömenden Luftstrom nur minimal. Die Länge des Kühlelements kann dabei so gewählt werden, dass das Kühlelement an einem möglichst hohen Anteil seiner Oberfläche von Luft umströmt wird. Es ist insbesondere nicht notwendig, das Kühlelement über die Fensteröffnung hinaus zu verlängern, damit das Kühlelement mit einer eventuell unterhalb der Fensteröffnung angebrachten Halterung in Eingriff treten kann. Somit wird auch die Stirnfläche des aus der Leiterplatte ragenden Abschnitts des Kühlelementes 350 zur Wärmeabgabe genutzt. In vorteilhafter Weise bewirkt die Querrippe innerhalb der Fensteröffnung gleichzeitig eine Versteifung des Gehäuses im Bereich der Fensteröffnungen.

Durch die Verwendung einer Halterung können auch größere und somit schwerere Kühlelemente verwendet werden, um eine bessere Kühlwirkung zu erzielen.

Wie in der Fig. 4a illustriert, kann ebenfalls eine Fensteröffnung 308 für jeweils zwei oder mehrere Kühlelemente vorgesehen werden.

Vorzugsweise ist die Querstrebe oder Querrippe 310 so ausgebildet, dass die Öffnung in der Querstrebe oder Querrippe 310, in die das Kühlelement eingesetzt wird, einen geringfügig geringeren Durchmesser als das Kühlelement aufweist. Wenn des Weiteren zumindest der Randbereich dieser Öffnung eine gewisse Elastizität aufweist, ist das Kühlelement nach dem Einsetzen in der Halterung 310 sicher fixiert.

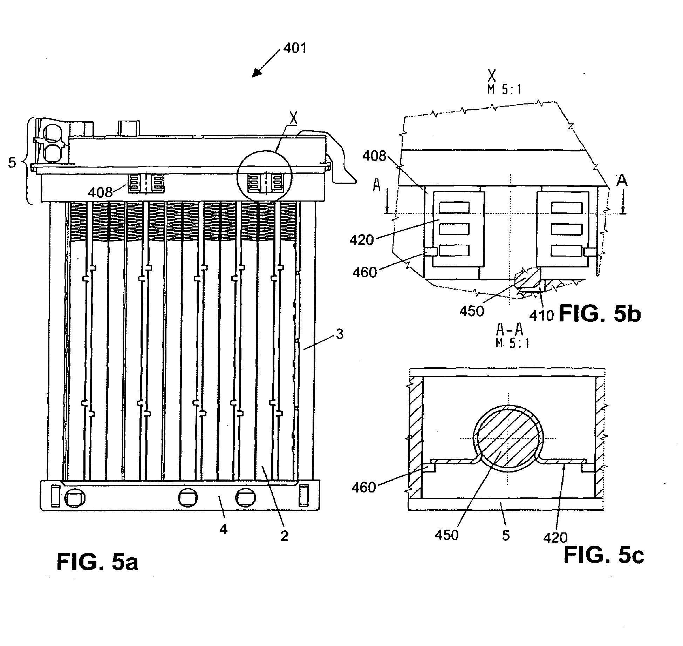

In den Figuren Fig. 5a, Fig. 5b und Fig. 5c ist eine weitere vorteilhafte Ausgestaltung der bisher beschriebenen erfindungsgemäßen Heizvorrichtung dargestellt. Insbesondere zeigt Fig. 5a eine Seitenansicht einer solchen Heizvorrichtung. Fig. 5b zeigt einen Detailausschnitt im Bereich einer Fensteröffnung dieser Heizvorrichtung. Fig. 5c zeigt einen Querschnitt entlang einer Linie A-A innerhalb der Fensteröffnung in Aufsicht.

Die Kühlelemente 450 sowie die Steuerschaltung (nicht gezeigt) entsprechen im Wesentlichen den in Fig. 2 und Fig. 3a, 3b gezeigten Ausführungsformen. Gemäß der in den Fig. 5a bis 5c abgebildeten Ausführungsform ist das stiftförmige Kühlelement 450 zusätzlich mit einem Kühlblech 420 versehen, um die Kühlwirkung weiter zu steigern. Dieses Kühlblech 420 ist vorzugsweise im Bereich der Fensteröffnung 408 an dem stiftförmigen Kühlelement 450 angebracht.

Das Kühlblech kann in einfacher Weise an die thermischen und mechanischen Anforderungen, die an die jeweiligen Heizungen gestellt werden, angepasst werden. Dies geschieht durch eine Auswahl eines geeigneten Materials, einer Oberflächenstruktur und der Form des Kühlblechs. Somit kann auf einfache Weise ein Basiskühlelement, nämlich das stiftförmige Kühlelement 450, an verschiedene Anforderungen angepasst werden.

Das Kühlblech ist vorzugsweise so ausgebildet, dass es auf den Kühlstift 450 aufgeklemmt werden kann. Dazu ist das Kühlblech 420 vorzugsweise in Ω-Form gebogen. Das Kühlblech umgreift den Kühlstift 450, um mit diesem eine Klemmverbindung einzugehen. Seitliche Abschnitte des Kühlblechs 420 stehen von dem Kühlstift vor, um die aufgenommene Wärme an den durch die Fensteröffnungen 408 durchgängigen Luftstrom abzugeben. Für das Kühlblech werden vorzugsweise Kupfer oder Aluminium verwendet. Aluminium zeichnet sich durch eine gute um verwendet. Aluminium zeichnet sich durch eine gute Wärmeleitfähigkeit und geringe Materialkosten aus. Kupfer hat eine hervorragende Wärmeleitfähigkeit. Auf der Grundlage des ausgewählten Materials wird die Materialstärke so bestimmt, dass ein zuverlässiger fester Klemmsitz des Kühlelements auf dem Kühlstift 450 gewährleistet ist. Die vom Kühlstift 450 abstehenden Abschnitte des Kühlblechs 420 sind in Form von Kühlfingern oder Kühlrippen gestaltet, um die vom Kühlstift aufgenommene Wärme möglichst effizient an die vorbeiströmende Luft abzugeben.

In der gezeigten Ausführungsform ist zusätzlich ein Anschlag 460 für das Kühlblech vorgesehen. Das Kühlblech 420 kann mit dem Anschlag 460 zur Befestigung verklebt werden. In einer solchen Anordnung dient das Kühlblech neben der Erhöhung der Kühlwirkung zugleich dem Zweck der zusätzlichen Fixierung des Kühlstifts. Dadurch wird ebenfalls ein sicherer Betrieb der Heizung über eine lange Zeitdauer gewährleistet.

Alternativ zu dieser Befestigung mittels des Kühlblechs kann der Kühlstift 450 innerhalb des Gehäuses fixiert sein. In der dargestellten Ausführungsform ist eine Vertiefung 410 in einer Querstrebe des Gehäuses gebildet, in die der Kühlstift 450 zum Fixieren eingesetzt wird. Mit einer solchen Anordnung lässt sich die Steuerschaltung mit den daran befestigten Kühlelementen auf einfache Weise in das Gehäuse der Heizvorrichtung einsetzen.

Zusammenfassend betrifft die vorliegende Erfindung eine elektrische Heizvorrichtung als Zusatzheizung für Kraftfahrzeuge, bei der das Heizregister und die Steuervorrichtung zu einer baulichen Einheit integriert sind. Zur Ansteuerung der Heizelemente des Heizregisters sind direkt auf der Leiterplatte montierte Leistungstransistoren vorgesehen. Zur effizienten Abführung der Verlustwärme von den Leistungstransistoren werden diese direkt über Öffnungen in der Leiterplatte an ihrer Unterseite von einem Kühlelement kontaktiert. Um die Herstellung zu vereinfachen, ist das Kühlelement als stiftförmiger Vollkörper ausgebildet. Zur Anbindung an den Leistungstransistor ist das Kühlelement in die jeweilige Öffnung eingesetzt und ragt aus der Unterseite der Leiterplatte senkrecht heraus.

## Patentansprüche

1. Elektrische Heizvorrichtung mit mehreren zu einem Heizblock zusammengesetzten Heizelementen (2) und einer Steuervorrichtung zur Ansteuerung der Heizelemente (2), wobei die Steuervorrichtung mit dem Heizblock eine bauliche Einheit bildet, sowie mit auf einer Leiterplatte (110) angeordneten Leistungstransistoren (119) und diesen zugeordneten Kühlelementen (150, 250), wobei ein Kühlelement (150, 250) jeweils durch eine Öffnung (140) in der Leiterplatte (110) an den jeweiligen Leistungstransistor (119) angebunden ist und so weit aus der Leiterplatte (110) herausragt, dass es jeweils über in einem Gehäuse (5) der Heizvorrichtung vorgesehene Fensteröffnungen (7, 307, 308, 408) von der zu erwärmenden Luft umströmbar ist,
**dadurch gekennzeichnet, dass**
ein Kühlelement (150, 250) jeweils als stiftförmiger Vollkörper ausgebildet ist, wobei das Kühlelement (150, 250) zur Anbindung an den Leistungstransistor (119) in die jeweilige Öffnung (140) eingesetzt ist und aus der Unterseite der Leiterplatte (110) senkrecht herausragt und dass
in dem Gehäuse (5) eine Halterung (310, 410) zur Fixierung des aus der Leiterplatte (110) herausragenden Abschnitts (152, 252, 253) des Kühlelementes (350, 450) vorgesehen ist.

2. Elektrische Heizvorrichtung nach Anspruch 1, wobei die Halterung durch eine Querstrebe des Gehäuses (5) gebildet ist, die eine Öffnung (310) oder Vertiefung (410) aufweist, in die das Kühlelement hineinragt.

3. Elektrische Heizvorrichtung nach Anspruch 1 oder 2 wobei die Halterung als eine zwischen sich gegenüberliegenden Fensteröffnungen (307, 308) angeordnete Querrippe (310) ausgebildet ist.

4. Elektrische Heizvorrichtung nach einem der Ansprüche 1 bis 3, wobei die Oberfläche des Kühlelements (150, 250) auf der Außenseite mit einer elektrisch isolierenden Beschichtung versehen ist.

5. Elektrische Heizvorrichtung nach einem der Ansprüche 1 bis 4, wobei die Oberfläche des Kühlelements (150, 250) im wesentlichen nur in dem zwischen die Fensteröffnungen hineinragenden Bereich mit einer elektrisch isolierenden Beschichtung versehen ist.

6. Elektrische Heizvorrichtung nach einem der Ansprüche 1 bis 5, wobei das Kühlelemente (150, 250) eine im Wesentlichen zylindrische Form aufweist.

7. Elektrische Heizvorrichtung nach einem der Ansprüche 1 bis 6, wobei der von der Leiterplatte (110) herausragende Abschnitt (253) des Kühlelements (250) radiale Vorsprünge oder Einkerbungen aufweist.

8. Elektrische Heizvorrichtung nach einem der Ansprüche 1 bis 7, wobei ein leiterplattenseitiger Abschnitt des Kühlelements (150, 250) in die jeweilige Öffnung (140) eingepresst ist.

9. Elektrische Heizvorrichtung nach Anspruch 8, wobei der leiterplattenseitiger Abschnitt (151, 251) des Kühlelements (150, 250) eine Rändelung aufweist, die sich beim Einpressen mit der Leiterplatte (110) verzahnt.

10. Elektrische Heizvorrichtung nach Anspruch 8 oder 9, wobei der leiterplattenseitiger Abschnitt (151, 251) des Kühlelements (150, 250) einen größeren Umfang hat als der aus der Leiterplatte (110) herausragende Abschnitt (152, 252, 253) des Kühlelementes (150, 250).

11. Elektrische Heizvorrichtung nach Anspruch 10, wobei der leiterplattenseitige Abschnitt (151, 251) des Kühlelements (150, 250) eine konische Form aufweist, die sich in Richtung des aus der Leiterplatte herausragenden Abschnitts (152, 252, 253) verjüngt.

12. Elektrische Heizvorrichtung nach einem der Ansprüche 1 bis 11, wobei die Leiterplatte (110) in einem Bereich (141) um einen Rand der Öffnung (140) mit Kupfer beschichtet ist.

13. Elektrische Heizvorrichtung nach einem der Ansprüche 1 bis 12, wobei das Kühlelement (150, 250) aus Kupfer oder Aluminium gefertigt ist.

14. Elektrische Heizvorrichtung nach einem der Ansprüche 1 bis 13, wobei das Kühlelement (150, 250) einen kreisförmigen Querschnitt mit einem Durchmesser zwischen 4 und 11 mm, vorzugsweise zwischen 6 und 9 mm, aufweist.

15. Elektrische Heizvorrichtung nach einem der Ansprüche 1 bis 14, wobei das Kühlelement (150, 250) eine Länge zwischen 15 und 40 mm, vorzugsweise zwischen 20 und 30 mm, aufweist.

16. Elektrische Heizvorrichtung nach einem der Ansprüche 1 bis 15, **gekennzeichnet durch** ein Kühlblech (420), das an dem Kühlelement (450) befestigt ist.

17. Elektrische Heizvorrichtung nach Anspruch 16, wobei das Kühlblech (420) zur Befestigung an dem Kühlelement (450) auf das Kühlelement (450) aufgeklemmt ist.

18. Elektrische Heizvorrichtung nach Anspruch 16 oder 17, wobei das Kühlblech (420) aus Aluminium oder Kupfer gefertigt ist.

19. Elektrische Heizvorrichtung nach einem der Ansprüche 16 bis 18, wobei das Kühlblech (420) an einem Gehäuse (5) der Heizvorrichtung befestigt ist.

20. Elektrische Heizvorrichtung nach einem der Ansprüche 1 bis 19, wobei der Leistungstransistor (119) mit dem jeweiligen, in die Öffnungen der Leiterplatte (110) eingesetzten Kühlelement (150, 250) verlötet ist.

21. Elektrische Heizvorrichtung nach einem der Ansprüche 1 bis 19, wobei der Leistungstransistor(119) mit dem jeweiligen, in die Öffnungen der Leiterplatte (110) eingesetzten Kühlelement (150, 250) verklebt ist.

22. Elektrische Heizvorrichtung nach Anspruch 21, wobei der Kleber ein Epoxidharzkleber, eine Silikonkleber oder ein Acrylkleber ist.

## Claims

1. Electric heating device with several heating elements (2) assembled to form a heating block and with a control device for controlling the heating elements (2), wherein the control device forms a structural unit with the heating block, and with power transistors (119) arranged on a circuit board (110) and cooling elements (150, 250) assigned to these, wherein a cooling element (150, 250) is connected in each case to the respective power transistor (119) through an opening (140) in the circuit board (110) and protrudes so far out of the circuit board (110) that the air to be heated can flow round it in each case via window openings (7, 307, 308, 408) provided in a housing (5) of the heating device, **characterized in that** each cooling element (150, 250) is formed as a pin-shaped solid body, wherein the cooling element (150, 250) is inserted into the respective opening (140) for connection to the power transistor (119) and protrudes vertically from the underside of the circuit board (110) and that a holder (310, 410) is provided in the housing (5) for fixing the section (152, 252, 253) of the cooling element (350, 450) protruding from the circuit board (110).

2. Electric heating device according to claim 1, wherein the holder is formed by a cross-member of the housing (5), which cross-member has an opening (310) or recess (410) into which the cooling element protrudes.

3. Electric heating device according to claim 1 or 2, wherein the holder is formed as a cross-rib (310) arranged between opposing window openings (307, 308).

4. Electric heating device according to one of claims 1 to 3, wherein the surface of the cooling element (150, 250) is provided on the outside with an electrically insulating coating.

5. Electric heating device according to one of claims 1 to 4, wherein the surface of the cooling element (150, 250) is provided with an electrically insulating coating substantially only in the area protruding between the window openings.

6. Electric heating device according to one of claims 1 to 5, wherein the cooling element (150, 250) has a substantially cylindrical shape.

7. Electric heating device according to one of claims 1 to 6, wherein the section (253) of the cooling element (250) protruding from the circuit board (110) has radial projections or notches.

8. Electric heating device according to one of claims 1 to 7, wherein a section of the cooling element (150, 250) on the circuit board side is pressed into the respective opening (140).

9. Electrical heating device according to claim 8, wherein the section (151, 251) of the cooling element (150, 250) on the circuit board side has knurling, which interlocks with the circuit board (110) on pressing in.

10. Electrical heating device according to claim 8 or 9, wherein the section (151, 251) of the cooling element (150, 250) on the circuit board side has a greater circumference than the section (152, 252, 253) of the cooling element (150, 250) protruding from the circuit board (110).

11. Electrical heating device according to claim 10, wherein the section (151, 251) of the cooling element (150, 250) on the circuit board side has a conical shape, which tapers in the direction of the section (152, 252, 253) protruding from the circuit board.

12. Electric heating device according to one of claims 1 to 11, wherein the circuit board (110) is coated with copper in an area (141) around an edge of the opening (140).

13. Electric heating device according to one of claims 1 to 12, wherein the cooling element (150, 250) is produced from copper or aluminium.

14. Electric heating device according to one of claims 1 to 13, wherein the cooling element (150, 250) has a circular cross-section with a diameter between 4 and 11 mm, preferably between 6 and 9 mm.

15. Electric heating device according to one of claims 1 to 14, wherein the cooling element (150, 250) has a length between 15 and 40 mm, preferably between 20 and 30 mm.

16. Electric heating device according to one of claims 1 to 15, **characterized by** a cooling plate (420), which is attached to the cooling element (450).

17. Electric heating device according to claim 16, wherein the cooling plate (420) is clamped onto the cooling element (450) for attachment to the cooling element (450).

18. Electric heating device according to claim 16 or 17, wherein the cooling plate (420) is produced from aluminium or copper.

19. Electric heating device according to one of claims 16 to 18, wherein the cooling plate (420) is attached to a housing (5) of the heating device.

20. Electric heating device according to one of claims 1 to 19, wherein the power transistor (119) is soldered to the respective cooling element (150, 250) inserted into the openings in the circuit board (110).

21. Electric heating device according to one of claims 1 to 19, wherein the power transistor (119) is glued to the respective cooling element (150, 250) inserted into the openings in the circuit board (110).

22. Electric heating device according to claim 21, wherein the adhesive is an epoxy resin adhesive, a silicone adhesive or an acrylic adhesive.

## Revendications

1. Dispositif de chauffage électrique avec plusieurs éléments chauffants (2) assemblés en un bloc de chauffage et un dispositif de commande pour la commande des éléments chauffants (2), dans lequel le dispositif de commande forme une unité modulaire avec le bloc de chauffage, et avec des transistors de puissance (119) disposés sur une plaque conductrice (110) et des éléments refroidisseurs (150, 250) associés à ceux-ci, dans lequel un élément refroidisseur (150, 250) est relié au transistor de puissance correspondant (119) à travers une ouverture (140) dans la plaque conductrice (110) et fait saillie hors de la plaque conductrice (110) par l'intermédiaire de baies (7, 307, 308, 408) prévues dans un boîtier (5) du dispositif de chauffage jusqu'où l'air à réchauffer puisse s'écouler autour,
**caractérisé en ce que**
un élément refroidisseur (150, 250) est réalisé sous forme de corps plein en forme de broche, l'élément refroidisseur (150, 250) étant inséré dans l'ouverture correspondante (140) pour être relié au transistor de puissance (119) et faisant saillie perpendiculairement hors de la face inférieure de la plaque conductrice (110) et **en ce que**
il est prévu dans le boîtier (5) un support (310, 410) pour la fixation du segment (152, 252, 253) de l'élément refroidisseur (350, 450) faisant saillie hors de la plaque conductrice (110).

2. Dispositif de chauffage électrique selon la revendication 1, dans lequel le support est constitué par une entretoise du boîtier (5) qui comporte une ouverture (310) ou un creux (410) dans lequel l'élément refroidisseur fait saillie.

3. Dispositif de chauffage électrique selon la revendication 1 ou 2, dans lequel le support est réalisé sous forme d'une nervure transversale (310) disposée entre des baies opposées (307, 308).

4. Dispositif de chauffage électrique selon l'une quelconque des revendications 1 à 3, dans lequel la surface de l'élément refroidisseur (150, 250) est munie sur la face extérieure d'un revêtement électriquement isolant.

5. Dispositif de chauffage électrique selon l'une quelconque des revendications 1 à 4, dans lequel la surface de l'élément refroidisseur (150, 250) est munie d'un revêtement électriquement isolant sensiblement uniquement dans la zone faisant saillie à l'intérieur entre les baies.

6. Dispositif de chauffage électrique selon l'une quelconque des revendications 1 à 5, dans lequel l'élément refroidisseur (150, 250) a une forme sensiblement cylindrique.

7. Dispositif de chauffage électrique selon l'une quelconque des revendications 1 à 6, dans lequel le segment (253) de l'élément refroidisseur (250) faisant saillie hors de la plaque conductrice (110) est muni de parties en saillie ou d'encoches radiales.

8. Dispositif de chauffage électrique selon l'une quelconque des revendications 1 à 7, dans lequel un segment de l'élément refroidisseur (150, 250) du côté de la plaque conductrice est enfoncé dans l'ouverture correspondante (140).

9. Dispositif de chauffage électrique selon la revendication 8, dans lequel le segment (151, 251) de l'élément refroidisseur (150, 250) du côté de la plaque conductrice est muni d'un moletage qui s'engrène dans la plaque conductrice (110) lorsqu'il est enfoncé.

10. Dispositif de chauffage électrique selon la revendication 8 ou 9, dans lequel le segment (151, 251) de l'élément refroidisseur (150, 250) du côté de la plaque conductrice a une circonférence plus grande que celle du segment (152, 252, 253) de l'élément refroidisseur (150, 250) faisant saillie hors de la plaque conductrice (110).

11. Dispositif de chauffage électrique selon la revendication 10, dans lequel le segment (151, 251) de l'élément refroidisseur (150, 250) du côté de la plaque conductrice a une forme conique qui s'amincit en direction du segment (152, 252, 253) faisant saillie hors de la plaque conductrice.

12. Dispositif de chauffage électrique selon l'une quelconque des revendications 1 à 11, dans lequel la plaque conductrice (110) est revêtue de cuivre dans une zone (141) autour d'un bord de l'ouverture (140).

13. Dispositif de chauffage électrique selon l'une quelconque des revendications 1 à 12, dans lequel l'élément refroidisseur (150, 250) est fait en aluminium ou en cuivre.

14. Dispositif de chauffage électrique selon l'une quelconque des revendications 1 à 13, dans lequel l'élément refroidisseur (150, 250) a une section transversale circulaire avec un diamètre compris entre 4 mm et 11 mm, de préférence entre 6 mm et 9 mm.

15. Dispositif de chauffage électrique selon l'une quelconque des revendications 1 à 14, dans lequel l'élément refroidisseur (150, 250) a une longueur comprise entre 15 mm et 40 mm, de préférence entre 20 mm et 30 mm.

16. Dispositif de chauffage électrique selon l'une quelconque des revendications 1 à 15, comprenant une tôle de refroidissement (420) qui est fixée à l'élément refroidisseur (450).

17. Dispositif de chauffage électrique selon la revendication 16, dans lequel la tôle de refroidissement (420) pour la fixation à l'élément refroidisseur (450) est serrée sur l'élément refroidisseur (450).

18. Dispositif de chauffage électrique selon la revendication 16 ou 17, dans lequel la tôle de refroidissement (420) est faite en aluminium ou en cuivre.

19. Dispositif de chauffage électrique selon l'une quelconque des revendications 16 à 18, dans lequel la tôle de refroidissement (420) est fixée à un boîtier (5) du dispositif de chauffage.

20. Dispositif de chauffage électrique selon l'une quelconque des revendications 1 à 19, dans lequel le transistor de puissance (119) est brasé avec l'élément refroidisseur (150, 250) correspondant inséré dans les ouvertures de la plaque conductrice (110).

21. Dispositif de chauffage électrique selon l'une quelconque des revendications 1 à 19, dans lequel le transistor de puissance (119) est collé avec l'élément refroidisseur (150, 250) correspondant inséré dans les ouvertures de la plaque conductrice (110).

22. Dispositif de chauffage électrique selon la revendication 21, dans lequel la colle est une colle de résine époxy, une colle de silicone ou une colle acrylique.
